# EUROPEAN PATENT APPLICATION

(11) **EP 4 645 528 A1**
(43) Date of publication of application: **05.11.2025**
(21) Application number: 23909127.5
(22) Date of filing: 19.07.2023
(51) Int. Cl.: H01M 10/6556

(54) **ENERGY STORAGE CABINET**

(30) Priority: 30.12.2022 CN 202223600559 U
(71) Applicant: BYD Company Limited, Shenzhen, Guangdong 518118 (CN)
(72) Inventor: SUI, Jiahai, Shenzhen, Guangdong 518118 (CN); YIN, Xueqin, Shenzhen, Guangdong 518118 (CN); CAO, Hu, Shenzhen, Guangdong 518118 (CN); ZHONG, Yalin, Shenzhen, Guangdong 518118 (CN); YIN, Xiaoqiang, Shenzhen, Guangdong 518118 (CN)
(74) Representative: Mathys & Squire
(86) International application number: PCT/CN2023/108055
(87) International publication number: WO 2024/139184

(57) **Abstract**

An energy storage cabinet, including a cabinet body, a battery assembly, an air cooling device, an upper air duct, a first air duct, and a second air duct. The upper air duct is arranged in an accommodating cavity and located on the upper portion of the cabinet body; the upper air duct is provided with an upper air duct inlet and an upper air duct outlet; the upper air duct inlet is in communication with an air outlet of the air cooling device; the first air duct and the second air duct are respectively located on two opposite sides of the battery assembly; the first air duct is provided with a first air duct inlet and a first air duct outlet; the second air duct is provided with a second air duct inlet and a second air duct outlet; the first air duct inlet and the second air duct inlet are respectively in communication with the upper air duct outlet; and the first air duct outlet and the second air duct outlet are respectively in communication with the battery assembly.

## Description

### CROSS-REFERENCE TO RELATED APPLICATIONS

The present disclosure claims priority to Chinese Patent Application No. 202223600559.7 filed on December 30, 2022, entitled "ENERGY STORAGE CABINET", which is incorporated herein by reference in its entirety.

### FIELD

The present disclosure relates to the field of heat dissipation technology, and in particular to an energy storage cabinet.

### BACKGROUND

Outdoor energy storage cabinets generate a large amount of heat during use. In order to ensure the normal use of outdoor energy storage cabinets, it is necessary to cool down the outdoor energy storage cabinets in time. In related technologies, the cooling systems of outdoor energy storage cabinets mainly include air cooling systems and water cooling systems. The air cooling systems have the advantages of a simple structure, safe cooling medium, easy maintenance and low cost, and has become the main cooling system. However, the existing air cooling systems have a relatively single and simple air duct and flow direction. The temperature of the cooling air gradually increases along the flow path of the cooling air duct, resulting in large temperature differences within the battery module. Especially in large-capacity battery energy storage systems, it causes the temperature of local battery energy storage modules to be relatively high, affecting its lifespan, and in severe cases, may lead to thermal runaway.

### SUMMARY

The present disclosure is intended to resolve one of technical problems in the related art at least to some extent. Therefore, an object of the present disclosure is to provide an energy storage cabinet that has excellent temperature uniformity performance.

The energy storage cabinet according to the present disclosure includes: a cabinet body, a battery assembly, an air cooling device, an upper air duct, a first air duct and a second air duct, the cabinet body has an accommodating cavity, the battery assembly is located in the accommodating cavity, the air cooling device is arranged in the accommodating cavity and configured to exchange heat with the outside of the cabinet body to generate cold air inside the cabinet body; the air cooling device is provided with an air cooling device air outlet and an air cooling device return air inlet, the air cooling device return air inlet is in communication with the interior of the cabinet body; the upper air duct is arranged in the accommodating cavity and located on the upper portion of the cabinet body, and the upper air duct is provided with an upper air duct inlet and an upper air duct outlet; the upper air duct inlet is in communication with the air cooling device air outlet; the first air duct and the second air duct are respectively located on two opposite sides of the battery assembly, the first air duct is provided with a first air duct inlet and a first air duct outlet; the second air duct is provided with a second air duct inlet and a second air duct outlet; the first air duct inlet and the second air duct inlet are respectively in communication with the upper air duct outlet; the first air duct outlet and the second air duct outlet are respectively in communication with the battery assembly.

According to the energy storage cabinet of the present disclosure, by arranging the first air duct and the second air duct on two opposite sides of the battery assembly, cold air is introduced from opposite sides of the battery assembly to cool it, which reduces the time for cold air to reach different positions of the battery assembly and improves the temperature uniformity performance of the battery assembly.

According to some embodiments of the present disclosure, the battery assembly includes a first side face, a second side face, a third side face and a fourth side face; the first side face is opposite to the third side face, and the second side face is opposite to the fourth side face; the first air duct is located between the first side face of the battery assembly and the cabinet body, and the second air duct is located between the third side face of the battery assembly and the cabinet body; the second side face and the fourth side face are respectively provided with a first gap and a second gap between them and the cabinet body.

According to some embodiments of the present disclosure, the air cooling device is an air conditioner.

According to some embodiments of the present disclosure, an opening is provided on one side of the cabinet body, and the energy storage cabinet further includes a cabinet door, the cabinet door is movably connected to the cabinet body to open or close the opening; the air conditioner is mounted to the cabinet door.

The cabinet door is arranged on the energy storage cabinet to facilitate the later maintenance of the energy storage cabinet. The air conditioner is mounted to the cabinet door, which is not only convenient for maintenance of the air conditioner and but also helps to save the internal space of the cabinet body and increase the volumetric energy density of the energy storage cabinet.

According to some embodiments of the present disclosure, the battery assembly includes a plurality of battery cells, the plurality of battery cells are stacked along the height direction of the cabinet body, and a layer gap is provided between adjacent battery cells to allow cold air to flow between the battery cells and cool the battery cells.

According to some embodiments of the present disclosure, the first air duct is provided with a plurality of first air duct outlets along the height direction of the cabinet body, and the second air duct is provided with a plurality of second air duct outlets along the height direction of the cabinet body, and the plurality of first air duct outlets and second air duct outlets are respectively corresponding to and in communication with the layer gaps one by one, such that cold air flows through each layer of the battery cells.

According to some embodiments of the present disclosure, the air conditioner and the first air duct are located on the same side of the battery assembly, or the air conditioner and the second air duct are located on the same side of the battery assembly.

According to some embodiments of the present disclosure, the first air duct and the second air duct are respectively attached to the battery assembly to enclose the first side face and the third side face of the battery assembly.

In this way, it can be ensured that the cold air flows between the battery cells through the first air duct outlet and the second air duct outlet to dissipate heat for the battery cells.

According to some embodiments of the present disclosure, the upper air duct outlet includes an upper air duct first outlet and an upper air duct second outlet, and the upper air duct first outlet and the upper air duct second outlet are respectively located on two opposite sides of the battery assembly, the upper air duct first outlet is in communication with the air inlet of the first air duct, and the upper air duct second outlet is in communication with the air inlet of the second air duct.

According to some embodiments of the present disclosure, the cabinet body is in a rectangular shape and has a width dimension W1, a depth dimension D1 and a height dimension H1, and satisfies: 1000mm ≤ W1 ≤ 1192mm, 1100mm ≤ D1 ≤ 1219mm, 1850mm ≤ H1 ≤ 2746mm.

The energy storage cabinet of the present disclosure has an air conditioning structure and a first air duct/second air duct on one side of the battery assembly, an upper air duct at the upper end of the battery assembly, and a second air duct/first air duct on the other side of the battery assembly. The cold air of the air conditioner's internal circulation enters the upper air duct through the air outlet, and then enters the first air duct and the second air duct respectively, and then enters from the front and rear ends of the gaps between each layer of battery cells, and then returns from the gaps on the left and right sides of the battery cells to form a cycle. The temperature uniformity between each layer of battery cells is improved, and the heat dissipation effect is improved.

The additional aspects and advantages of the present disclosure are partially provided in the following descriptions, some of which will become apparent from the following descriptions or may be learned from practices of the present disclosure.

### BRIEF DESCRIPTION OF THE DRAWINGS

The above and/or additional aspects and advantages of the present disclosure will become apparent and easy to understand from the description of the embodiments in combination with the following figures, in which:
FIG. 1 is a three-dimensional schematic diagram of an energy storage cabinet according to an embodiment of the present disclosure;
FIG. 2 is a three-dimensional schematic diagram of the energy storage cabinet shown in FIG. 1 without part of the cabinet body;
FIG. 3 is a schematic diagram of the structure inside the accommodating cavity of the energy storage cabinet;
FIG. 4 is a three-dimensional assembly diagram of the upper air duct, the first air duct and the second air duct;
FIG. 5 is a schematic diagram of the battery assembly structure;
FIG. 6 is a schematic diagram of the flow direction of cold air in the energy storage cabinet according to an embodiment of the present disclosure, and the arrow direction is the flow direction of the air;
FIG. 7 is a schematic diagram of the flow of cold air between battery cells, and the arrow direction is the flow direction of the air.

### Figure symbols:

Energy storage cabinet 10, cabinet body 100, accommodating cavity 101, cabinet door 102, battery assembly 200, battery cell 201, layer gap 202, air cooling device 300, air cooling device air outlet 301, upper air duct 400, upper air duct inlet 401, upper air duct outlet 402, first air duct 500, first air duct inlet 501, second air duct 600, second air duct inlet 601.

### DETAILED DESCRIPTION

The embodiments of the present disclosure are described below in detail. The embodiments described with reference to the accompanying drawings are exemplary. The embodiments of the present disclosure are described in detail below.

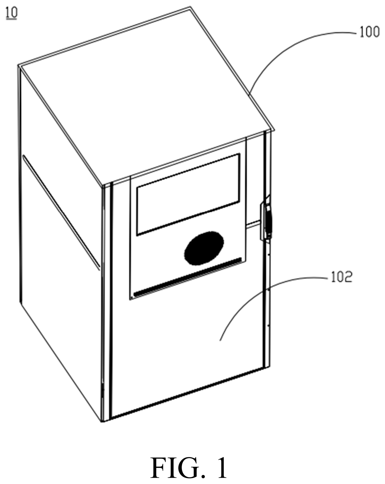

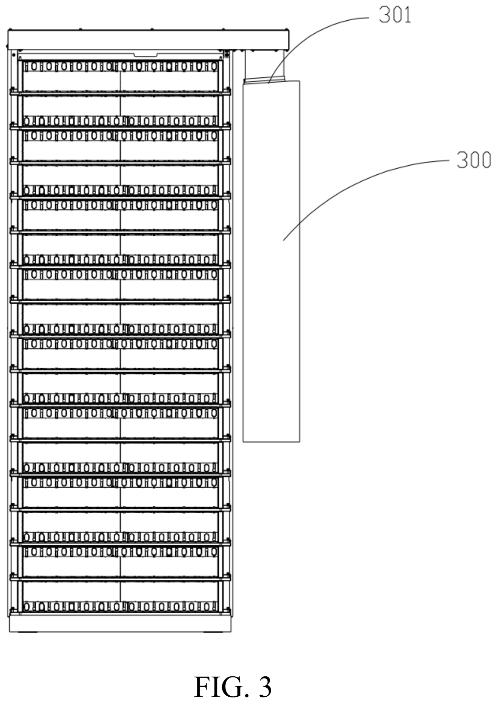

The energy storage cabinet 10 according to the embodiment of the present disclosure is described below with reference to FIG. 1 to FIG. 7. The energy storage cabinet 10 includes: a cabinet body 100, a battery assembly 200, an air cooling device 300, an upper air duct 400, a first air duct 500 and a second air duct 600.

The cabinet body 100 has an accommodating cavity 101, and the battery assembly 200 is located in the accommodating cavity 101.

The air cooling device 300 is arranged in the accommodating cavity 101 and configured to exchange heat with the outside of the cabinet body 100 to generate cold air inside the cabinet body 100, and the cold air is used to cool the battery assembly 200 to reduce the temperature of the battery assembly 200; the air cooling device 300 is provided with an air cooling device air outlet 301 and an air cooling device return air inlet (not marked in the figure), and the air cooling device return air inlet is in communication with the interior of the cabinet body 100.

The upper air duct 400 is arranged in the accommodating cavity 101 and located on the upper portion of the cabinet body 100. The upper air duct 400 is provided with an upper air duct inlet 401 and an upper air duct outlet 402, and the upper air duct inlet 401 is in communication with the air cooling device air outlet 301.

The first air duct 500 and the second air duct 600 are respectively located on two opposite sides of the battery assembly 200. The first air duct 500 is provided with a first air duct inlet 501 and a first air duct outlet (not marked in the figure); the second air duct 600 is provided with a second air duct inlet 601 and a second air duct outlet (not marked in the figure); the first air duct inlet 501 and the second air duct inlet 601 are respectively in communication with the upper air duct outlet 402; the first air duct outlet and the second air duct outlet are respectively in communication with the battery assembly 200, and the cold air is simultaneously directed from two sides of the battery assembly 200 to the inside of the battery assembly 200 to cool the battery assembly 200.

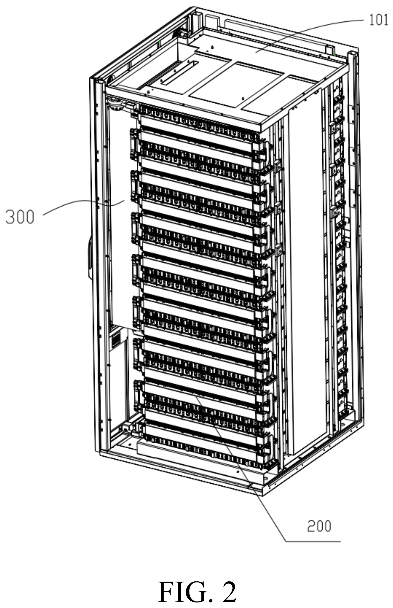

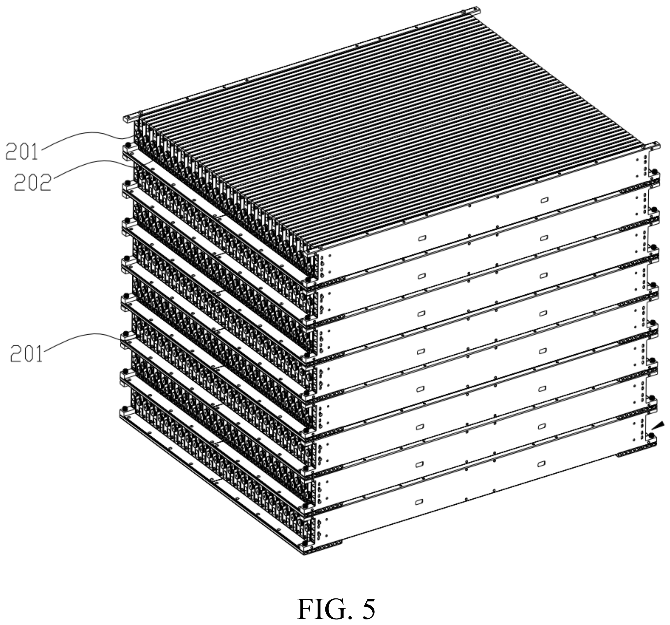

As shown in FIG. 2 and FIG. 5, the battery assembly 200 includes a first side face, a second side face, a third side face and a fourth side face; the first side face is opposite to the third side face, and the second side face is opposite to the fourth side face; the first air duct 500 is located between the first side face of the battery assembly 200 and the cabinet body 100, and the second air duct 600 is located between the third side face of the battery assembly 200 and the cabinet body 100; the second side face and the fourth side face are respectively provided with a first gap (not marked in the figure) and a second gap (not marked in the figure) between them and the cabinet body 100. The first gap and the second gap are respectively provided between the second side face and the fourth side face and the cabinet body 100. After the cold air cools the battery assembly 200, hot air is generated due to heat exchange. The hot air can enter the return air inlet of the air cooling device through the first gap and the second gap. The hot air entering the return air inlet of the air cooling device exchanges heat with the cold air outside the energy storage cabinet 10 again, so as to form cold air, and another cycle is carried out.

In an embodiment of the present disclosure, the air cooling device 300 is an air conditioner. Of course, the air cooling device 300 may also be other common equipment commonly used in the art that can achieve the purpose of the present disclosure.

In an embodiment of the present disclosure, as shown in FIG. 1, an opening is provided on one side of the cabinet body 100, and the energy storage cabinet 10 further includes a cabinet door 102, the cabinet door is movably connected to the cabinet body 100 to open or close the opening; the air conditioner is mounted to the cabinet door 102.

In an embodiment of the present disclosure, an opening is provided on one side of the cabinet body 100, and the cabinet door 102 is movably connected to the cabinet body 100 to facilitate opening or closing the opening. The opening and the cabinet door 102 are provided on the energy storage cabinet 10, so that the battery assembly 200 in the energy storage cabinet 10 can be easily repaired. Meanwhile, the air conditioner is mounted to the cabinet door 102, which is convenient for maintenance of the air conditioner on one hand, and save the storage space inside the cabinet body 100 further, improving the volumetric energy density of the energy storage cabinet 10.

In an embodiment of the present disclosure, as shown in FIG. 5, the battery assembly 200 includes a plurality of battery cells 201, the plurality of battery cells 201 are stacked along the height direction of the cabinet body 100, and a layer gap 202 is provided between adjacent battery cells 201 to allow cold air to flow between the battery cells 201 and cool the battery cells 201.

In the present disclosure, the battery assembly 200 comprises a plurality of battery cells 201 stacked along the height direction of the cabinet body 100, and a layer gap 202 is provided between adjacent battery cells 201, so that the cold air from the air conditioner passes through the upper air duct and enters the layer gaps 202 between the battery cells 201 through the first air duct 500 and the second air duct 600 respectively, and the cold air exchanges heat with the battery cells 201 in the layer gaps 202, taking away the heat generated by the battery cells 201, thereby cooling the battery cells 201.

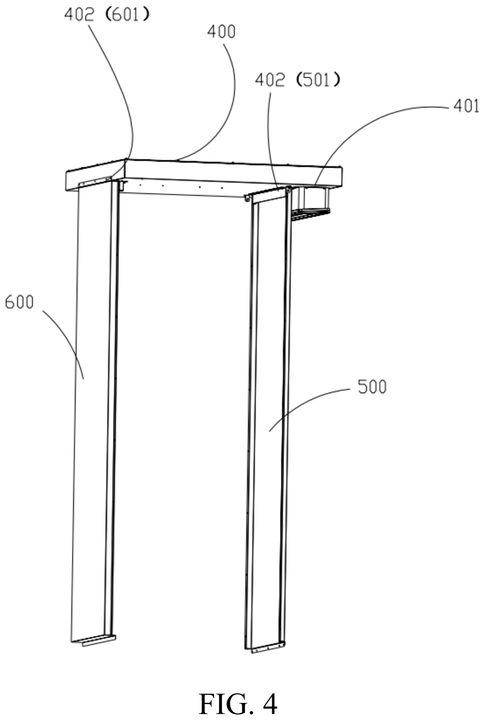

In an embodiment of the present disclosure, as shown in FIG. 4, the first air duct 500 and the second air duct 600 are respectively attached to the battery assembly 200 to enclose the first side face and the third side face of the battery assembly 200. In the present disclosure, in order to make full use of the cold air generated by the air conditioner, the present disclosure preferably attaches the first air duct 500 and the second air duct 600 to the battery assembly 200 to enclose the first side face and the third side face of the battery assembly 200. In this way, the cold air generated by the air conditioner does not leak out, but instead only flow between the battery cells 201 through the air outlet to cool the battery cells 201.

In an embodiment of the present disclosure, the first air duct 500 is provided with a plurality of first air duct outlets along the height direction of the cabinet body 100, and the second air duct 600 is provided with a plurality of second air duct outlets along the height direction of the cabinet body 100. The plurality of first air duct outlets and second air duct outlets are respectively corresponding to and in communication with the layer gaps 202 one by one, such that the cold air flows through each layer of the battery cells 201.

In the present disclosure, the first air duct 500 is provided with a plurality of first air duct outlets along the height direction of the cabinet body 100, and the second air duct 600 is provided with a plurality of second air duct outlets along the height direction of the cabinet body 100, and the plurality of first air duct outlets and second air duct outlets are respectively corresponding to and in communication with the layer gaps 202 one by one, such that the cold air flows through each layer of the battery cells 201. The air outlets of the first air duct and the air outlets of the second air duct are respectively corresponding to the layer gaps 202, to ensure that the cold air can flow between the battery cells 201 and to ensure that the cold air does not overflow, thereby better improving the cooling effect.

In an embodiment of the present disclosure, the air conditioner and the first air duct 500 are located on the same side of the battery assembly 200, or the air conditioner and the second air duct 600 are located on the same side of the battery assembly 200.

In the present disclosure, the air conditioner is located on the cabinet door 102. In the art, the side of the energy storage cabinet 10 with the cabinet door 102 is often regarded as the front (face) of the energy storage cabinet 10, the other side relative to the front is the rear, and the two sides adjacent to the front are the left side and the right side respectively. In an embodiment of the present disclosure, one of the first air duct 500 or the second air duct 600, for example, the first air duct 500 is set in front of the energy storage cabinet 10, and the other air duct, for example, the second air duct 600 is set at the rear of the energy storage cabinet 10. In this way, the energy storage cabinet 10 sends the cold air into the upper air duct 400 at the top of the energy storage cabinet 10 through the front air conditioner, and then enters the first air duct 500 in front and the second air duct 600 in the rear respectively, and flows between the battery cells 201 from the front and rear of the battery cells 201 through the air outlets of the first air duct 500 and the second air duct 600, respectively, to cool the battery cells 201, and the cold air is converted into hot air through heat exchange, and the hot air enters the return air inlet of the air conditioner through the first gap and the second gap on the left and right sides of the battery cells 201, forming an air cooling circulation system for the battery assembly 200.

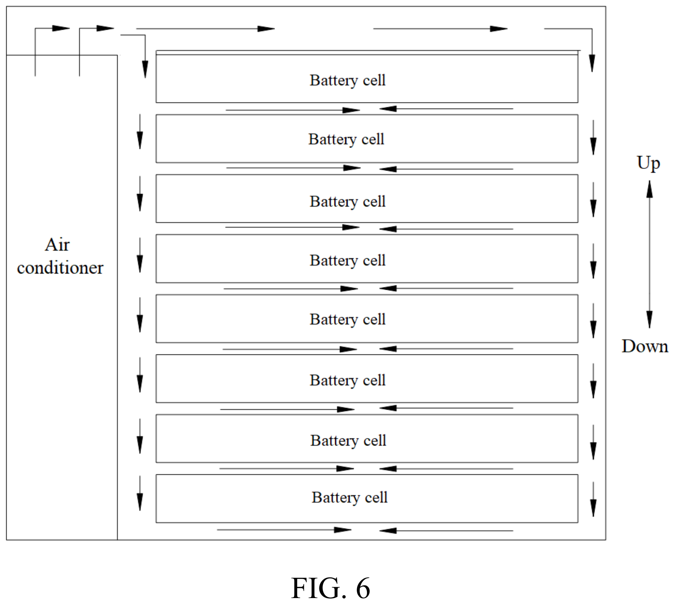

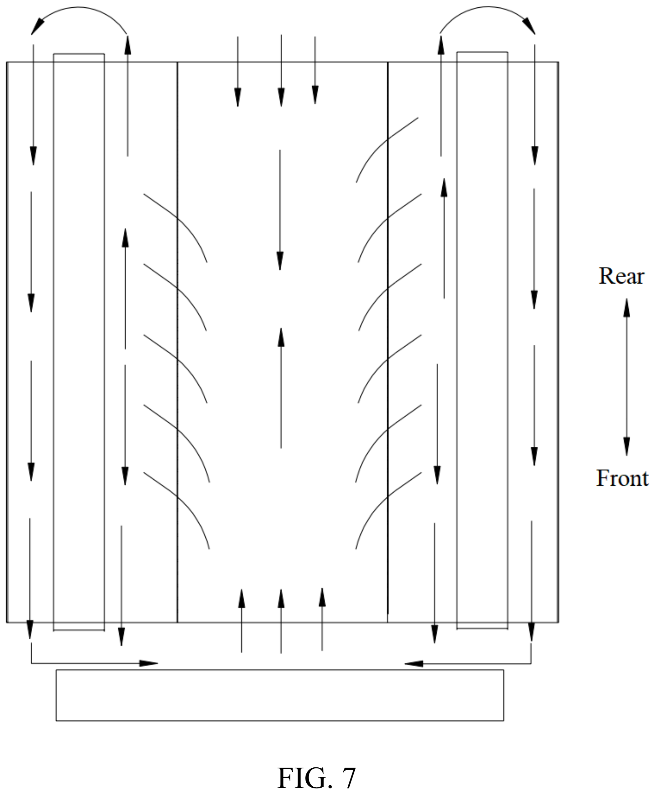

In the present disclosure, as shown in FIG. 6, the cold air from the air conditioner enters the first air duct 500 and the second air duct 600 respectively after passing through the upper air duct 400, and then flows between the battery cells 201 from the front and rear sides of the battery cells 201 through the first air duct 500 and the second air duct 600 respectively, to cool the battery cells 201. As further shown in FIG. 7, the cold air flowing between the battery cells 201 from the front and rear sides converges on the surface of the battery cells 201, diffuses to the left and right sides of the battery cells 201 driven by the air speed, and enters the return air inlet of the air conditioner through the first gap and the second gap on the left and right sides, forming a cycle.

In an embodiment of the present disclosure, the upper air duct outlet 402 includes a upper air duct first outlet and a upper air duct second outlet, and the upper air duct first outlet and the upper air duct second outlet are respectively located on opposite sides of the battery assembly 200, the upper air duct first outlet is in communication with the air inlet 501 of the first air duct 500, and the upper air duct second outlet is in communication with the air inlet 601 of the second air duct 600.

In the present disclosure, in order to make it more convenient for the upper air duct 400 to communicate with the first air duct 500 and the second air duct 600, a first air outlet and a second air outlet are respectively provided on the upper air duct 400. In this way, the first air outlet is in communication with the air inlet 501 of the first air duct 500, and the second air outlet is in communication with the air inlet 601 of the second air duct 600. Thus, the cold air can directly enter the first air duct 500 and the second air duct 600 through the first air outlet and the second air outlet.

In some embodiments, the cabinet body 100 is in a rectangular shape and has a width dimension W1, a depth dimension D1 and a height dimension H1, and satisfies: 1000mm≤ W1≤1192mm, a single cabinet body 100 has a depth of 1100mm≤D1≤1219mm, and a height dimension of 1850mm≤H1≤2746mm.

In the energy storage cabinet 10 of the present disclosure, the cold air of the air conditioner's internal circulation flows into the upper air duct 400 through the air outlet of the air conditioner. A part of the cold air reaches the rear side of the energy storage cabinet 10 along the upper air duct 400, and enters the second air duct 600 along the second air duct inlet 601, and a part of the cold air enters the first air duct 500 along the first air duct inlet 501. The cold air in the first air duct 500 and the second air duct 600 will enter the layer gaps between the battery cells 201 and circulate along the direction of the arrow. Since the front and rear ducts are independently attached to the front and rear sides of the battery cells 201, the cold air on the front and rear sides cannot overflow. The cold air exchanges heat with the hot air generated by the battery cells 201. The hot air then overflows from the gaps on the left and right sides of the battery cells 201 and enters the interior of the cabinet body 100. The air is then drawn back by the fan of the air conditioner's internal circulation. This cycle is repeated to dissipate heat for the battery assembly 200 in the cabinet body 100. The air cooling structure of the present disclosure has a good cooling effect and provides good temperature uniformity of the battery cells 201.

In the description of the present disclosure, it should be understood that the terms "center", "longitudinal", "lateral", "length", "width", "thickness", "up", "down", "front", "rear", "left", "right", "vertical", "horizontal", "up", "bottom", "inside", "outside", etc. indicate orientation or positional relationships based on the orientation or positional relationships shown in the drawings, which are only for the convenience of describing the present disclosure and simplifying the description, and do not indicate or imply that the device or element referred to must have a specific orientation, be constructed and operated in a specific orientation, and therefore cannot be understood as limitations on the present disclosure.

In the description of the present disclosure, "first feature" and "second feature" may include one or more of the features.

In the description of the present disclosure, the first feature "above" or "below" the second feature may include the first and second features being in direct contact, or the first and second features being in contact not directly but through another feature between them.

In the description of the present disclosure, the first feature being "above", "over" and "on" the second feature include the first feature being directly above and obliquely above the second feature, or simply indicating that the first feature is horizontally higher than the second feature.

In description of this specification, description of reference terms "an embodiment", "some embodiments", "illustrative embodiments", "examples", "specific examples", or "some examples" and the like means that specific features, structures, materials or characteristics described in combination with the embodiment(s) or example(s) are included in at least one embodiment or example of the present disclosure. In this specification, exemplary descriptions of the foregoing terms do not necessarily refer to the same embodiment or example.

Although the embodiments of the present disclosure have been shown and described, a person of ordinary skill in the art should understand that various changes, modifications, replacements and variations may be made to the embodiments without departing from the principles and purposes of the present disclosure. The scope of the disclosure is defined by the claims and their equivalents.

## Claims

1. An energy storage cabinet (10), comprising:
a cabinet body (100) having an accommodating cavity (101) therein;
a battery assembly (200), the battery assembly (200) being located in the accommodating cavity (101);
an air cooling device (300), the air cooling device (300) being arranged in the accommodating cavity (101) and configured to exchange heat with the outside of the cabinet body (100) to generate cold air inside the cabinet body (100); the air cooling device (300) being provided with an air cooling device air outlet (301) and an air cooling device return air inlet; the air cooling device return air inlet being in communication with the interior of the cabinet body (100);
an upper air duct (400), the upper air duct (400) being arranged in the accommodating cavity (101) and located on the upper portion of the cabinet body (100), the upper air duct (400) being provided with an upper air duct inlet (401) and an upper air duct outlet (402); the upper air duct inlet (401) being in communication with the air cooling device air outlet (301);
a first air duct (500) and a second air duct (600), the first air duct (500) and the second air duct (600) being respectively located on two opposite sides of the battery assembly (200), the first air duct (500) being provided with a first air duct inlet (501) and a first air duct outlet; the second air duct (600) being provided with a second air duct inlet (601) and a second air duct outlet; the first air duct inlet (501) and the second air duct inlet (601) being respectively in communication with the upper air duct outlet (402); the first air duct outlet and the second air duct outlet being respectively in communication with the battery assembly (200).

2. The energy storage cabinet (10) according to claim 1, wherein the battery assembly (200) comprises a first side face, a second side face, a third side face and a fourth side face; the first side face is opposite to the third side face, and the second side face is opposite to the fourth side face; the first air duct (500) is located between the first side face of the battery assembly (200) and the cabinet body (100), and the second air duct (600) is located between the third side face of the battery assembly (200) and the cabinet body (100); the second side face and the fourth side face are respectively provided with a first gap and a second gap between them and the cabinet body (100).

3. The energy storage cabinet (10) according to claim 1 or 2, wherein the air cooling device (300) is an air conditioner.

4. The energy storage cabinet (10) according to claim 3, wherein an opening is provided on one side of the cabinet body (100), and the energy storage cabinet (10) further comprises a cabinet door (102), the cabinet door (102) is movably connected to the cabinet body (100) to open or close the opening; the air conditioner is mounted to the cabinet door (102).

5. The energy storage cabinet (10) according to claim 4, wherein the battery assembly (200) comprises a plurality of battery cells (201), the plurality of battery cells (201) are stacked along the height direction of the cabinet body (100), and a layer gap (202) is provided between adjacent battery cells (201) to allow cold air to flow between the battery cells (201) and cool the battery cells (201).

6. The energy storage cabinet (10) according to claim 5, wherein the first air duct (500) is provided with a plurality of first air duct outlets along the height direction of the cabinet body (100), and the second air duct (600) is provided with a plurality of second air duct outlets along the height direction of the cabinet body (100), and the plurality of first air duct outlets and second air duct outlets are respectively corresponding to and in communication with the layer gaps (202) one by one, such that the cold air flows through each layer of the battery cells (201).

7. The energy storage cabinet (10) according to claim 6, wherein the air conditioner and the first air duct (500) are located on the same side of the battery assembly (200), or the air conditioner and the second air duct (600) are located on the same side of the battery assembly (200).

8. The energy storage cabinet (10) according to claim 2, wherein the first air duct (500) and the second air duct (600) are respectively attached to the battery assembly (200) to enclose the first side face and the third side face of the battery assembly (200).

9. The energy storage cabinet (10) according to any one of claims 1 to 8, wherein the upper air duct outlet (402) comprises an upper air duct first outlet and an upper air duct second outlet, and the upper air duct first outlet and the upper air duct second outlet are respectively located on two opposite sides of the battery assembly (200), the upper air duct first outlet is in communication with the air inlet of the first air duct (500), and the upper air duct second outlet is in communication with the air inlet of the second air duct (600).

10. The energy storage cabinet (10) according to any one of claims 1 to 9, wherein the cabinet body (100) is in a rectangular shape and has a width dimension W1, a depth dimension D1 and a height dimension H1, and satisfies: 1000mm ≤ W1 ≤ 1192mm, 1100mm ≤ D1 ≤ 1219mm, 1850mm≤H1≤2746 mm.
